# EUROPEAN PATENT APPLICATION

(11) **EP 2 706 364 A1**
(43) Date of publication of application: **12.03.2014**
(21) Application number: 12275134.0
(22) Date of filing: 06.09.2012
(51) Int. Cl.: G01R 31/02

(54) **Electrode line monitoring unit**

(71) Applicant: Alstom Technology Ltd, 5400 Baden (CH)
(72) Inventor: Couch, Philips Robin, Cotleigh, Honiton Devon, EX149HG (GB); Stott, Timothy James, Audley, Stoke-on-Trent Staffordshier, ST7 8JH (GB)
(74) Representative: Potter Clarkson LLP

(57) **Abstract**

An electrode line monitoring unit (10) for monitoring an electrode line (18) comprises:
a communications device (14) including a transmitter (22) to transmit, in use, a signal; and
a power supply (16) including a power extraction circuit for connection, in use, into the electrode line (18) such that a voltage drop (V) is generated across the power extraction circuit so as to provide a primary voltage source to power one or more other components (12,14) of the electrode line monitoring unit (10), wherein the power extraction circuit includes at least one power electronic device (24) with a non-linear voltage-current characteristic.

## Description

This invention relates to an electrode line monitoring unit and an electrode line monitoring assembly, for use in HVDC power transmission.

In power transmission networks alternating current (AC) power is typically converted to direct current (DC) power for transmission via overhead lines and/or undersea cables. This conversion removes the need to compensate for the AC capacitive load effects imposed by the transmission line or cable, and thereby reduces the cost per kilometer of the lines and/or cables. Conversion from AC to DC thus becomes cost-effective when power needs to be transmitted over a long distance. Such a power transmission network is referred to as a high voltage, direct current (HVDC) power transmission system.

An HVDC power transmission system typically includes a connection to ground via a grounding electrode. The connection to ground may serve as a ground reference or a monopole return path for the HVDC system. One or more electrode lines is used to interconnect the HVDC system and a grounding electrode.

According to a first aspect of the invention, there is provided an electrode line monitoring unit for monitoring an electrode line comprising:
a communications device including a transmitter to transmit, in use, a signal; and
a power supply including a power extraction circuit for connection, in use, into the electrode line such that a voltage drop is generated across the power extraction circuit so as to provide a primary voltage source to power one or more other components of the electrode line monitoring unit, wherein the power extraction circuit includes at least one power electronic device with a non-linear voltage-current characteristic.

The electrode line may be an overhead electrode line or a buried electrode line.

In use, one or more characteristics of the electrode line is monitored and measured in order to ensure safe and reliable operation of the electrode line and other electrical equipment associated with the electrode line.

The provision of the communications device in the electrode line monitoring unit allows a signal that includes, for example, information about the or each monitored characteristic of the electrode line to be communicated between the electrode line monitoring unit and an end user, such as an HVDC control station. This is useful when there is a considerable distance between a part of the electrode line that is being monitored and the end user as a result of the monitored part of the electrode line being situated in a remote location, far away from the end user. For example, an earthed electrode at one end of an electrode line is typically situated in a remote location, far away from an HVDC control station connected to the other end of the electrode line.

The communicated information is then used to determine whether the or each monitored characteristic of the electrode line falls within normal operating parameters. For example, the information may be communicated from one end of the electrode line to an HVDC control station at the other end of the electrode line to permit end-to-end DC differential measurement in order to detect whether a fault has occurred in the electrode line.

Furthermore, other than or together with information about the or each characteristic of the electrode line, the signal may include one or more of: control instructions to control, in use, one or more electrode line monitoring units; configuration data to configure, in use, one or more electrode line monitoring units; information about a status of one or more end users and/or one or more electrode line monitoring units.

The inclusion of the communications device in the electrode line monitoring unit permits control instructions and/or configuration data received from an end user to be transmitted to another electrode line monitoring unit further along the electrode line. Furthermore, the configuration of the electrode line monitoring unit allows information about the status of the electrode line monitoring unit to be regularly transmitted to the end user to verify that the electrode line monitoring unit is functioning properly.

The provision of the power supply allows power to be harvested from the electrode line so as to provide a primary voltage source to power one or more other components of the electrode line monitoring unit. In particular, the primary voltage source is used to power the communications device. The reliance of the power supply on current flow in the electrode line ensures that the supply of power to one or more other components of the electrode line monitoring unit will not be interrupted as long as current flows through the electrode line, thus providing the electrode line monitoring unit with a reliable power supply.

The electrode line may be required to operate under different current flow conditions. If the electrode line is being used as a ground reference, there will be a small, steady-state DC earth current, e.g. less than 5 A, flowing in the electrode line. If the electrode line is being used as a monopole return path, there will be a large, steady-state DC current, e.g. more than 3000 A, flowing in the electrode line. If there is a disturbance in a system associated with the electrode line, the electrode line may carry a substantial, transient current, e.g. more than 18 kA.

The or each power electronic device may be, but is not limited to, a semi-conductor device, such as a power diode or a thyristor.

The use of at least one power electronic device with a non-linear voltage-current characteristic in the power extraction circuit means that generation of a voltage drop across the power extraction circuit will be minimally affected by a variation in operating conditions that causes a change in current flow in the electrode line. This allows the power supply to provide a steady, reliable voltage source to power one or more other components of the electrode line monitoring unit.

In addition, the manner in which the power extraction circuit harvests power from the electrode line allows the electrode line monitoring unit to be installed at a location that is near a ground electrode at one end of the electrode line, where the voltage with respect to ground is low.

When the electrode line monitoring unit is used in combination with a bipolar HVDC power transmission system, a small imbalance in current may be deliberately introduced into the bipolar HVDC power transmission system whenever the electrode line monitoring unit is in use. This is because, in a bipolar HVDC power transmission system, the HVDC control station would attempt to balance the current levels at both poles and thereby effectively attempt to zero the electrode line current. In practice, however, measurement inaccuracies result in a low, non-zero current in the electrode line. It was found that this low, non-zero current is sufficient to generate a voltage drop that is sufficiently large to provide a primary voltage source for one or more other low-power components of the electrode line monitoring unit.

The provision of the power supply therefore results in a self-contained electrode line monitoring unit with its own reliable power supply. This therefore obviates the need to use an additional, local power supply, e.g. an external power generator, to power one or more other components of the electrode line monitoring unit. Otherwise omission of the power extraction circuit from the electrode line monitoring unit would require an additional, lower power supply to be built near the electrode line monitoring unit. This can be costly and time-consuming in terms of transporting parts to the installation site and installing the additional, local power supply. This is particularly the case when the additional, local power supply is to be installed either in a remote or sparsely populated location or in a local environment that is unsuitable for installation of the additional, local power supply.

In embodiments of the invention, the electrode line monitoring unit may further include a sensor device to measure, in use, the or each characteristic of the electrode line. In such embodiments, the primary voltage source may be used to power the sensor device.

The sensor device may include a single sensor to measure a single characteristic of the electrode line or a plurality of sensors to measure a plurality of characteristics of the electrode line. The or each characteristic of the electrode line may be selected from a group that includes, but is not limited to, line connectivity, current level and temperature.

The use of at least one power electronic device in the power extraction circuit is advantageous in that the size and cost of the electrode line monitoring unit may be minimised through use of one or more, cheap and compact power electronic devices.

In embodiments of the invention, the power extraction circuit may include a plurality of power electronic devices connected in an anti-parallel arrangement. For example, the power extraction unit may include a single power electronic device connected with another single power electronic device in an anti-parallel arrangement. Furthermore, either or each of the single power electronic devices in the anti-parallel arrangement may be replaced by a plurality of power electronic devices connected in series and/or parallel, e.g. a pair of series-connected power electronic devices.

Using an anti-parallel arrangement to connect the plurality of power electronic devices in the power extraction circuit allows power to be extracted from the electrode line, regardless of the direction of current flow in the electrode line. This also allows the power extraction circuit to continue extracting power from the electrode line in the event of a reversal in voltage drop across the plurality of power electronic devices.

Upon failure of one or more power electronic devices, the or each failed power electronic device may form a short circuit that permits, in use, electrode line current to pass through the power extraction circuit. This prevents interruption of current flow in the electrode line in the event of failure of one or more power electronic devices of the power extraction circuit.

The communications device may be any type of communications device that is capable of transmitting information either wirelessly or via a physical signal transmission medium to another device. For example, the communications device may be or may include, but is not limited to, an optical communications device, an electrical communications device and/or a radio communications device.

The electrode line monitoring unit may further include at least one signal transmission medium connected to the communications device to carry, in use, a signal. The or each signal transmission medium may be, but is not limited to, an electrical cable or an optical fibre.

When the electrode line monitoring assembly employs the use of at least one signal transmission medium, the or each signal transmission medium may be mounted on or fastened to the electrode line, or may be integrated with the electrode line.

The arrangement of the or each signal transmission medium and the electrode line in this manner provides additional support to the or each signal transmission medium that either interconnects an electrode line monitoring unit and the end user, or interconnects different electrode line monitoring units.

In addition, the arrangement of the or each signal transmission medium and the electrode line as set out above may be used to detect a fault in the electrode line. For example, when the or each signal transmission medium is an optical fibre, a break in the electrode line may inhibit the ability of the optical fibre to carry a signal. This results in a loss of communication to and from the electrode line monitoring unit, which may be used to indicate an occurrence of a break in the electrode line.

In embodiments of the invention, the communications device may further include a receiver to receive, in use, a signal. In use, the signal may be transmitted from the end user, e.g. the HVDC control station, or from another electrode line monitoring unit. As mentioned earlier, the signal may include one or more of: information about one or more characteristics of the electrode line; control instructions to control, in use, one or more electrode line monitoring units; configuration data to configure, in use, one or more electrode line monitoring units; information about a status of one or more end users and/or one or more electrode line monitoring units.

Furthermore, the inclusion of a receiver in the communications device not only allows the electrode line monitoring unit to act as an intermediary between another electrode line monitoring unit and the end user, but also permits the use of a plurality of electrode line monitoring units to form an electrode line monitoring assembly that monitors the or each characteristic of the electrode line at different points along the electrode line. This is particularly useful for an electrode line with a considerable length.

In certain circumstances, monitoring of the or each characteristic of the electrode line may only be required at a particular point along the electrode line, but the physical distance between that point and the end user may be sufficiently large to require one or more intermediate electrode line monitoring units to establish communication between the end user and that point. In this regard, one or more electrode line monitoring units that omit a sensor device may be used as an intermediary or intermediaries between the end user and an electrode line monitoring unit with a sensor device, thus resulting in cost savings due to the lack of a sensor device in the or each intermediate electrode line monitoring unit. Such circumstances include, but are not limited to, end-to-end DC differential measurement.

In such embodiments employing the use of a receiver, the electrode line monitoring unit may include a communications repeater device to retransmit, in use, the received signal, wherein the communications repeater device includes the transmitter and the receiver.

The length of the electrode line may lead to degradation of the signal during its transmission from an electrode line monitoring unit to the end user. The use of a communications repeater device however allows an electrode line monitoring unit to regenerate a degraded signal received from another electrode line monitoring unit, before sending the regenerated signal to another electrode line monitoring unit or the end user, thus improving the reliability of electrode line monitoring.

In further embodiments employing the use of a receiver, the communications device may be a bidirectional communications device that includes a pair of transmitters and a pair of receivers, and includes two communications repeater devices to retransmit, in use, a received signal, wherein each communications repeater device includes a transmitter and a receiver.

The configuration of the communications device in this manner allows the electrode line monitoring unit to act as an intermediary that establishes bidirectional communication between an end user and another electrode line monitoring unit, or between two other electrode line monitoring units.

In further embodiments of the invention, the electrode line monitoring unit may further include an energy storage device and/or an energy conversion device to provide a secondary voltage source so as to power one or more other components of the electrode line monitoring unit. In particular, the primary voltage source is used to power the communications device, and may be used to power the sensor device when the electrode line monitoring unit includes a sensor device. The energy storage device may be any type of energy storage device that is capable of storing and releasing energy, and may be, but is not limited to a battery, or a capacitor. The energy conversion device may be any type of energy conversion device that is capable of generating energy from the environment, and may be, but is not limited to, a solar cell. The energy conversion device may also be any type of energy conversion device that is capable of converting the type of energy stored by the energy storage device to and from electrical energy.

The energy storage device may be electrically coupled to the power extraction circuit to selectively charge the energy storage device.

Each of the energy storage device and the energy conversion device acts as a back-up power supply to ensure reliable operation of the electrode line monitoring unit, even when there is insufficient or zero current flow in the electrode line to permit sufficient power to be harvested by the power extraction circuit.

Generation of a voltage drop across the power extraction circuit may result in a rise in temperature of the electrode line monitoring unit due to energy dissipation.

The electrode line monitoring unit may further include a cooling system to regulate the temperature of the electrode line monitoring unit. The cooling system may be or may include, but is not limited to, a heat sink, a heat pipe, a fan and/or a convection chimney. The inclusion of a cooling system improves the safety and reliability of the electrode line monitoring unit by keeping its temperature within a designated temperature range.

The electrode line monitoring unit may further include a support to hold components of the electrode line monitoring unit, the support being mountable or fastenable, in use, to the electrode line and/or a support structure of the electrode line. The support may be, for example, in the form of a housing.

In this manner, the electrode line monitoring unit may be partly or wholly supported by the electrode line and/or the support structure of the electrode line. This results in an electrode line monitoring unit that may be installed anywhere along the electrode line, since the use of the support means that installation of the electrode line monitoring unit is minimally affected by the local environment. For example, the support may be used in locations in which the local environment is unsuitable for installation of the electrode line monitoring unit on the ground. As such, this removes the need to redesign the electrode line monitoring unit to accommodate different installation requirements along the electrode line due to a difference in local environment.

Moreover, the use of the support to hold components of the electrode line monitoring unit means that the electrode line monitoring unit is kept close to the electrode line. This allows the size, weight and cost of the electrode line monitoring unit to be decreased through reduction in the amount of material required to connect the electrode line and the power supply of the electrode line monitoring unit. The use of the support to hold components of the electrode line monitoring unit also means that the electrode line monitoring unit is kept close to any signal transmission medium that itself is supported by the electrode line. This allows the size, weight and cost of the or each signal transmission medium to be minimised.

Furthermore, the use of the support removes the need for the electrode line monitoring unit to be supported by a separate structure that itself is supported by the ground. This thereby removes the need to add insulation to insulate the electrode line monitoring unit from the ground. This leads to further savings in terms of size, weight and costs.

According to a second aspect of the invention, there is provided an electrode line monitoring assembly for monitoring an electrode line comprising a communications path, wherein the communications path includes a plurality of electrode line monitoring units to communicate at least one signal along the communications path, and each of the plurality of electrode line monitoring units is an electrode line monitoring unit according to any preceding claim.

As set out above, the electrode line monitoring unit includes a transmitter and a power supply, and may be configured to further include, amongst other optional features, a sensor, a receiver, or a combination of a receiver and a sensor. As such, the configuration of the electrode line monitoring unit lends itself to a modular approach in terms of its design and manufacture, which in turn simplifies construction of the electrode line monitoring assembly when it comes to manufacturing and installing a plurality of electrode line monitoring units with different optional features.

In the electrode line monitoring assembly, the plurality of electrode line monitoring units may include:
at least one electrode line monitoring unit according to any preceding embodiment of the first aspect of the invention, and
at least one other electrode line monitoring unit according to any preceding embodiment of the first aspect of the invention that employs the use of a receiver,
wherein at least one of the plurality of electrode line monitoring units is in communication with at least one other of the plurality of electrode line monitoring units so as to communicate at least one signal along the communications path.

The inclusion of a receiver in the communications device of one or more electrode line monitoring units permits the use of a plurality of electrode line monitoring units to form an electrode line monitoring assembly in which the plurality of electrode line monitoring units are positioned at different points along the electrode line and are in communication with each other to define the communications path. The communications path allows each electrode line monitoring unit positioned at a different point along the electrode line to be linked to the end user in order to communicate information, such as information about the or each characteristic of the electrode line at different points along the electrode line, control instructions from the end user to control, in use, each electrode line monitoring unit; configuration data from the end user to configure, in use, each electrode line monitoring unit; and/or information about a status of one or more end users and/or one or more electrode line monitoring units.

In further embodiments of the electrode line monitoring assembly, the communications path may be divided into a plurality of communications sub-paths, wherein each communications sub-path includes at least one of the plurality of electrode line monitoring units to communicate a signal along that communications sub-path.

The configuration of the electrode line monitoring assembly in this manner allows one of the plurality of communications sub-paths to be designated as a main communications sub-path, whilst the or each other communications sub-path is designated as a redundant communications sub-path that may take over the function of the main communications sub-path in the event that the main communications sub-path is unable to communicate a signal. This thereby improves the reliability of the electrode line monitoring assembly.

Preferred embodiments of the invention will now be described, by way of non-limiting examples, with reference to the accompanying drawings in which:
Figure 1 shows, in schematic form, an electrode line monitoring unit according to a first embodiment of the invention;
Figure 2 shows, in schematic form, an electrode line monitoring unit according to a second embodiment of the invention;
Figure 3 shows, in schematic form, an electrode line monitoring assembly according to a third embodiment of the invention;
Figure 4 shows, in schematic form, an electrode line monitoring assembly according to a fourth embodiment of the invention; and
Figure 5 shows, in schematic form, an electrode line monitoring unit according to a fifth embodiment of the invention; and
Figure 6 shows, in schematic form, an electrode line monitoring unit according to a sixth embodiment of the invention.

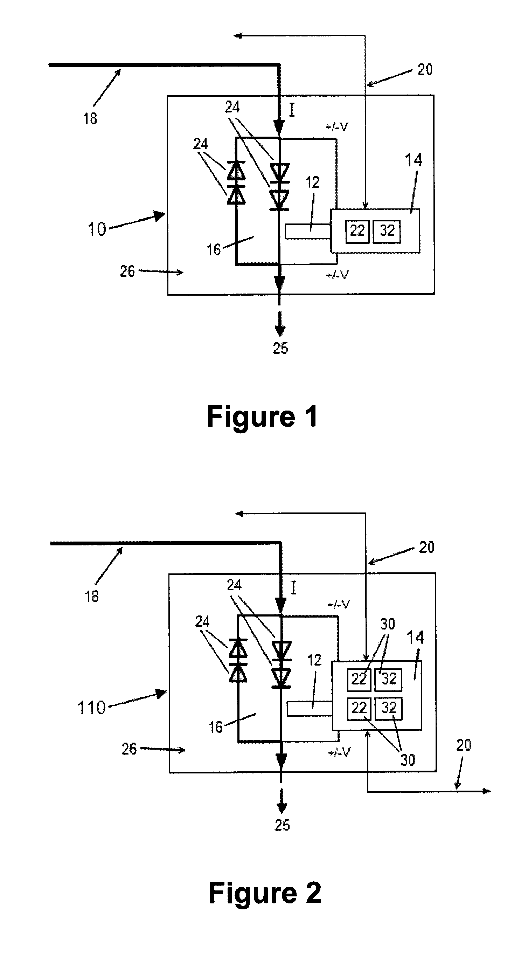

A first electrode line monitoring unit 10 according to a first embodiment of the invention is shown in Figure 1.

The first electrode line monitoring unit 10 includes a sensor device 12, a communications device 14 and a power supply 16.

The sensor device 12 includes a current sensor to measure, in use, current I in an electrode line 18.

It is envisaged that, in other embodiments, the sensor may be replaced by a different sensor to measure a different characteristic of the electrode line 18 or by a plurality of sensors to measure a plurality of characteristics of the electrode line 18. The or each characteristic of the electrode line 18 may be selected from a group that includes, but is not limited to, line connectivity, current level and temperature.

The communications device 14 is an optical communications device 14, and includes a transmitter 22 to transmit, in use, an optical signal. The communications device 14 further includes a receiver 32 to receive, in use, an optical signal.

It is envisaged that, in other embodiments, the communications device 14 may omit the receiver 32.

The first electrode line monitoring unit 10 further includes an optical fibre 20 connected to the optical communications device 14 to carry, in use, the transmitted/received signal. In use, the optical fibre 20 is integrated with the electrode line 18.

Optionally the optical fibre 20 may be mounted on or fastened to the electrode line 18.

The integration of the optical fibre 20 with the electrode line 18 in this manner provides additional support to the optical fibre 20.

It is envisaged that, in other embodiments, the optical communications device 14 may be replaced by another type of communications device. In such embodiments, the type of signal transmission medium used in the first electrode line monitoring unit 10 may vary depending on the format of the transmitted/received signal. For example, the optical fibre 20 may be replaced by another type of signal transmission medium such as an electrical cable. In other such embodiments, the first electrode line monitoring unit 10 may omit the use of a signal transmission medium if the communications device is able to carry out wireless signal transmission, such as radio serial digital transmission.

The power supply 16 includes a power extraction circuit, which includes a plurality of power electronic devices 24 connected in an anti-parallel arrangement. In particular, the power extraction circuit includes a pair of series-connected power electronic devices 24 connected with another pair of series-connected power electronic devices 24 in an anti-parallel arrangement.

In further embodiments, it is envisaged that each pair of series-connected power electronic devices 24 may be replaced by a single power electronic device, a pair of parallel-connected power electronic devices, or a different number of power electronic devices connected in series and/or parallel.

Each power electronic device 24 is a power diode with a non-linear voltage-current characteristic. In still further embodiments, it is envisaged that each power electronic device 24 may be replaced by a different power electronic device, e.g. a thyristor or another semiconductor device.

In use, the power extraction circuit is connected into the electrode line 18. In particular, the anti-parallel arrangement of the plurality of power electronic devices 24 is connected in series with the electrode line 18. As such, a voltage drop V is generated across the power extraction circuit when current flows in the electrode line 18. The voltage drop V generated across the power extraction circuit is used to provide a primary voltage source to power the sensor and communications devices 12,14.

The provision of the power supply 16 in the first electrode line monitoring unit 10 therefore allows power to be harvested from the electrode line 18 so as to provide a primary voltage source to power the sensor and communications devices 12,14 of the first electrode line monitoring unit 10.

In use, the electrode line 18 may be required to operate under different operating conditions. If the electrode line 18 is being used as a ground reference, there will be a small, steady-state DC earth current, e.g. less than 5 A, flowing in the electrode line 18. If the electrode line 18 is being used as a monopole return path, there will be a large, steady-state DC current, e.g. more than 3000 A, flowing in the electrode line 18. If there is a disturbance in a system associated with the electrode line 18, the electrode line 18 may carry a substantial, transient current, e.g. more than 18 kA.

The use of the plurality of power electronic devices 24 in the power extraction circuit means that generation of a voltage drop V across the power extraction circuit will be minimally affected by a variation in operating conditions that causes in a change in current flow in the electrode line 18. This allows the power supply 16 to provide a steady, reliable voltage source to power the sensor and communications devices 12,14 of the first electrode line monitoring unit 10. In addition, the manner in which the power extraction circuit harvests power from the electrode line 18 allows the first electrode line monitoring unit 10 to be installed at a location that is near a ground electrode 25 at one end of the electrode line 18, where the voltage with respect to ground is low.

In addition, using an anti-parallel arrangement to connect the plurality of power electronic devices 24 in the power extraction circuit allows power to be extracted from the electrode line 18, regardless of the direction of current flow in the electrode line 18. This also allows the power extraction circuit to continue extracting power from the electrode line 18 in the event of a reversal in voltage drop across the plurality of power electronic devices 24.

Optionally each power electronic device 24 may be selected such that, upon failure of one or more power electronic devices 24, the or each failed power electronic device 24 forms a short circuit that permits, in use, electrode line current I to pass through the power extraction circuit. This prevents interruption of current flow in the electrode line 18 in the event of failure of one or more power electronic devices 24 of the power extraction circuit.

It will be appreciated that other arrangements of the power extraction circuit may be used to generate a voltage drop V across the power extraction circuit when the power extraction circuit is connected into the electrode line 18, so as to provide the primary voltage source.

The first electrode line monitoring unit 10 further includes a housing 26 to house the sensor device 12, the communications device 14 and the power supply 16. The housing 26 is shaped such that the housing 26 can be mounted, in use, on the electrode line 18 and/or a support structure of the electrode line 18. Alternatively the housing 26 may be fastened, in use, to the electrode line 18 and/or a support structure of the electrode line 18.

In this manner, the first electrode line monitoring unit 10 may be partly or wholly supported by the electrode line 18 and/or the support structure of the electrode line 18. This results in an first electrode line monitoring unit that may be installed anywhere along the electrode line 18, since the use of the housing 26 means that installation of the first electrode line monitoring unit 10 is minimally affected by the local environment. For example, the housing 26 may be used in locations in which the local environment is unsuitable for installation of the first electrode line monitoring unit 10 on the ground. As such, this removes the need to redesign the first electrode line monitoring unit 10 to accommodate different installation requirements along the electrode line 18 due to a difference in local environment.

The use of the housing 26 to hold components of the first electrode line monitoring unit 10 also means that the first electrode line monitoring unit 10 is kept close to the optical fibre 20 that is integrated with the electrode line 18. This allows the size, weight and cost of the optical fibre 20 to be minimised.

Furthermore, the use of the housing 26 removes the need for the first electrode line monitoring unit 10 to be supported by a separate structure that itself is supported by the ground. This thereby removes the need to add insulation to insulate the first electrode line monitoring unit 10 from the ground. This leads to further savings in terms of size, weight and costs.

In other embodiments, it is envisaged that the housing 26 may be replaced by any other type of support that is capable of holding the components 12,14 of the first electrode line monitoring unit.

A second electrode line monitoring unit 110 according to a second embodiment of the invention is shown in Figure 2. The second electrode line monitoring unit 110 shown in Figure 2 is similar in terms of structure and operation to the first electrode line monitoring unit 10 shown in Figure 1, and like features share the same reference numerals.

The second electrode line monitoring unit 110 differs from the first electrode line monitoring unit 10 in that the communications device 14 of the second electrode line monitoring unit 110 is a bidirectional communications device 14 that further includes a pair of communications repeater devices 30.

The configuration of the communications device 14 in this manner allows the second electrode line monitoring unit 110 to act as an intermediary that establishes bidirectional communication between an end user and another electrode line monitoring unit, or between two other electrode line monitoring units.

In other embodiments, it is envisaged that the communication device 14 only includes a single communications repeater device 30.

Each communications repeater device 30 includes an optical transmitter 22, and an optical receiver 32.

The second electrode line monitoring unit 110 further includes a pair of optical fibres 20 connected to the optical communications device 14 to carry, in use, the received and transmitted signals that include information about the measured current level of the electrode line 18.

The provision of the communications repeater device 30 in the second electrode line monitoring unit 110 not only allows retransmission of a received signal, but also allows regeneration of a degraded signal before transmitting the regenerated signal.

It is envisaged that, in other embodiments, the type of receiver used in the communications repeater device 30 may vary depending on the format of the received signal.

The configuration of the electrode line monitoring units 10,110 set out above lends itself to a modular approach in terms of its design and manufacture, which in turn simplifies construction of an electrode line monitoring assembly when it comes to manufacturing and installing a plurality of electrode line monitoring units 10,110 with different features.

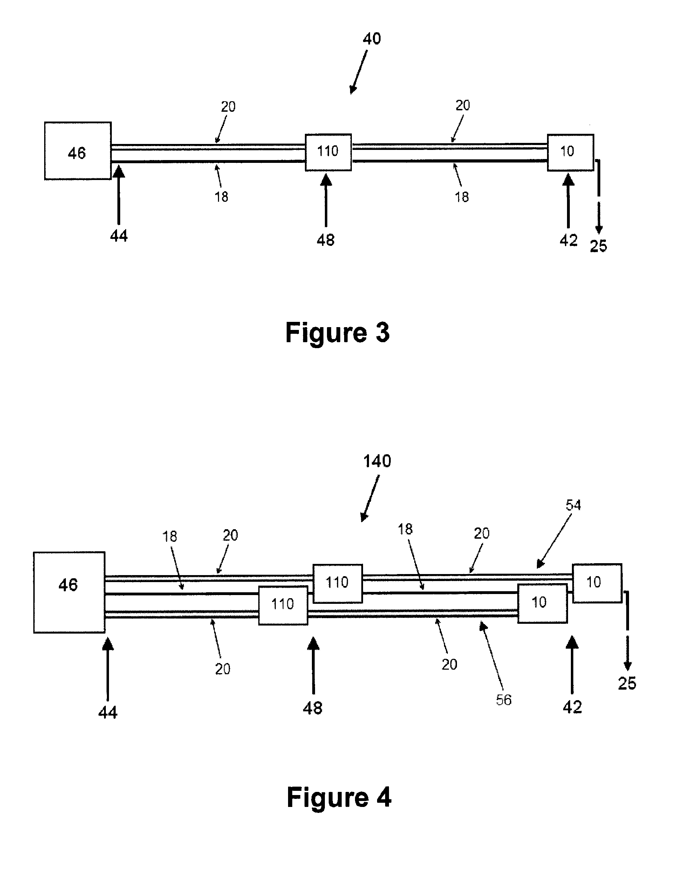

A first electrode line monitoring assembly 40 according to a third embodiment of the invention is shown in Figure 3.

The first electrode line monitoring assembly 40 includes an end electrode line monitoring unit 10 and an intermediate electrode line monitoring unit 110. The end electrode line monitoring unit 10 is identical in terms of structure and operation to the first electrode line monitoring unit 10 shown in Figure 1. The intermediate electrode line monitoring unit 110 is identical in terms of structure and operation to the second electrode line monitoring unit 110 shown in Figure 2.

In use, the end electrode line monitoring unit 10 is positioned at a first end 42 of an electrode line 18 that is connected to a grounding electrode 25, a second end 44 of the electrode line 18 is connected to an HVDC control station 46, and the intermediate electrode line monitoring unit 110 is connected at a mid-point 48 along the length of the electrode line 18 between the HVDC control station 46 and the end electrode line monitoring unit 10.

The optical fibre 20 of the end electrode line monitoring unit 10 is connected to the optical communications device 14 of the intermediate electrode line monitoring unit 110 to enable transmission, in use, of a signal between the end electrode line monitoring unit 10 and the intermediate electrode line monitoring unit 110.

The optical fibre 20 of the intermediate electrode line monitoring unit 110 is connected to the HVDC control station 46 to enable transmission, in use, of a signal between the intermediate electrode line monitoring unit 110 and the HVDC control station 46.

In this manner, the end and intermediate electrode line monitoring units 10,110 define a communications path in which the end and intermediate electrode line monitoring units 10,110 are in communication with each other, and are in communication with the HVDC control station 46.

Operation of the first electrode line monitoring assembly 40 to monitor the current levels of the electrode line 18 is described as follows, with reference to Figures 1 to 3.

The current sensors of the end and intermediate electrode line monitoring units 10,110 respectively measure the current levels of the electrode line 18 at the first end 42 of the electrode line 18 and the mid-point 48 along the length of the electrode line 18.

The optical communications device 14 of the end electrode line monitoring unit 10 then transmits a signal that includes information about the measured current level at the first end 42 of the electrode line 18. This signal is carried to the optical communications device 14 of the intermediate electrode line monitoring unit 110 via the optical fibre 20 that interconnects the end and intermediate electrode line monitoring units 10,110.

Once the signal reaches the optical communications device 14 of the intermediate electrode line monitoring unit 110, it is received by the receiver 32 of the intermediate electrode line monitoring unit 110. The communications repeater device 30 of the intermediate electrode line monitoring unit 110 may regenerate the signal received from the end electrode line monitoring unit 10 if any signal degradation has occurred. The received signal is then combined with a signal that includes information about the measured current level at the mid-point 48 along the length of the electrode line 18 so as to create a combined signal that includes information about the measured current levels at the first end 42 of the electrode line 18 and the mid-point 48 along the length of the electrode line 18. This is followed by the optical communications device 14 of the intermediate electrode line monitoring unit 110 transmitting the combined signal to the HVDC control station 46 via the optical fibre 20 that interconnects the intermediate electrode line monitoring unit 110 and the HVDC control station 46.

In this manner, information about the measured current levels of the measured current levels at the first end 42 of the electrode line 18 and the mid-point 48 along the length of the electrode line 18 is communicated along the communications path from each electrode line monitoring unit 10,110 to the HVDC control station 46. The communicated information is then used to determine whether the current levels of the electrode line 18 falls within normal operating parameters. This may be used to, for example, detect a fault occurring in the electrode line 18 that resulted in a change in current level in the electrode line 18.

The first electrode line monitoring assembly 40 therefore has the ability to remotely monitor the current levels at different points along the length of an electrode line 18 that interconnects an HVDC control station 46 and a grounding electrode 25. This ability is particularly useful when there is a considerable distance between the HVDC control station 46 and the grounding electrode 25, thus requiring a long electrode line 18.

In addition, the integration of the optical fibre 20 with the electrode line 18 as set out above may be used to detect a fault in the electrode line 18. For example, a break in the electrode line 18 may inhibit the ability of the optical fibre 20 to carry a signal. This results in a loss of communication in the communications path defined by the electrode line monitoring units 10,110 of the first electrode line monitoring assembly 40. This loss of communication may be used to indicate an occurrence of a break in the electrode line 18.

The provision of the power supply 16 in each electrode line monitoring unit 10,110 results in self-contained electrode line monitoring units 10,110, each having a reliable, local power supply 16, which improves the reliability of the first electrode line monitoring assembly 40.

The reliance of each power supply 16 on current flow in the electrode line 18 ensures that the supply of power to the components 12,14 of each electrode line monitoring unit 10,110 will not be interrupted as long as current flows through the electrode line 18, thus providing each electrode line monitoring unit 10,110 with a reliable power supply 16. The availability of a power supply 16 in each electrode line monitoring unit 10,110 is beneficial in that it obviates the need to use an additional, local power supply e.g. an external power generator, to power components 12,14 of each electrode line monitoring unit 10,110. Building the additional, local power supply near each electrode line monitoring unit 10,110 can be costly and time-consuming in terms of transporting parts to the installation site and installing the additional, local power supply. This is particularly the case when the additional, local power supply is to be installed in a remote or sparsely populated location or in a local environment that is unsuitable for installation of the additional, local power supply.

Other than or together with information about the or each characteristic of the electrode line, the HVDC control station 46 may transmit to each electrode line monitoring unit 10,110 a signal that includes: control instructions to control, in use, each electrode line monitoring unit 10,110; and/or configuration data to configure, in use, each electrode line monitoring unit 10,100. Furthermore, each electrode line monitoring unit 10,110 may transmit to the HVDC control station information about a status of that electrode line monitoring unit 10,110 on a regular basis to verify that the electrode line monitoring unit is functioning properly.

It is envisaged that, in other embodiments of the first electrode line monitoring assembly 40, the single intermediate electrode line monitoring unit 110 may be replaced by a plurality of intermediate electrode line monitoring units to interconnect the end electrode line monitoring unit 10 and the HVDC control station 46 so as to define a communication path which the end and intermediate electrode line monitoring units 10,110 are in communication with each other, and are in communication with the HVDC control station 46.

It is also envisaged that, in other embodiments of the first electrode line monitoring assembly 40, the intermediate electrode line monitoring unit 110 may omit the sensor device 12. Omission of the sensor device 12 from the intermediate electrode line monitoring unit 110 may be applicable to certain circumstances in which monitoring of the current of the electrode line 18 may only be required at the first end 42 along the electrode line 18, but the physical distance between the first end 42 of the electrode line 18 and the HVDC control station 44 may be sufficiently large to require one or more intermediate electrode line monitoring units 110 to establish communication between the first end 42 of the electrode line 18 and the HVDC control station 44. Such circumstances include, but are not limited to, end-to-end DC differential measurement. Thus, with reference to Figure 3, the intermediate electrode line monitoring unit 110 may be replaced by an intermediate electrode line monitoring unit 110 that omits the sensor device 12 so as to function as an intermediary to communicate a signal received from the end electrode line monitoring unit 10 to the HVDC control station 46. This results in cost savings due to the omission of a sensor device 12 in the intermediate electrode line monitoring unit 110.

It is further envisaged that, in other embodiments of the first electrode line monitoring assembly 40, the first electrode line monitoring assembly 40 may omit the intermediate electrode line monitoring unit 110, and the optical fibre 20 of the end electrode line monitoring unit 10 may be directly connected to the HVDC control station 46. In this manner, the end electrode line monitoring unit 10 is in direct communication with the HVDC control station 46.

A second electrode line monitoring assembly 140 according to a fourth embodiment of the invention is shown in Figure 4. The second electrode line monitoring assembly 140 shown in Figure 4 is similar in terms of structure and operation to the first electrode line monitoring assembly 40 shown in Figure 3, and like features share the same reference numerals.

The second electrode line monitoring assembly 140 differs from the first electrode line monitoring assembly 40 in that the second electrode line monitoring assembly 140 further includes an additional, end electrode line monitoring unit 10 and an additional, intermediate electrode line monitoring unit 110.

In use, the additional, end electrode line monitoring unit 10 is positioned at a first end 42 of the electrode line 18 that is connected to a grounding electrode 25, and the additional, intermediate electrode line monitoring unit 110 is connected at a mid-point 48 along the length of the electrode line 18 between the HVDC control station 46 and the additional, end electrode line monitoring unit 10.

The optical fibre 20 of the additional, end electrode line monitoring unit 10 is connected to the optical communications device 14 of the additional, intermediate electrode line monitoring unit 110 to enable transmission, in use, of a signal between the additional, end electrode line monitoring unit 10 and the additional, intermediate electrode line monitoring unit 110.

The optical fibre 20 of the additional, intermediate electrode line monitoring unit 110 is connected to the HVDC control station 46 to enable transmission, in use, of a signal between the additional, intermediate electrode line monitoring unit 110 and the HVDC control station 46.

In this manner, the end and intermediate electrode line monitoring units 10,110 define a communications path that is divided into a pair of communications sub-paths 54,56. Each communications sub-path 54,56 includes one of the end electrode line monitoring units 10 and one of the intermediate electrode line monitoring units 110 to communicate a signal along that communications sub-path 54,56. In each communications sub-path 54,56, the end and intermediate electrode line monitoring units 10,110 are in communication with each other, and are in communication with the HVDC control station 46.

The configuration of the second electrode line monitoring assembly 140 in this manner allows one of the plurality of communications sub-paths 54,56 to be designated as a main communications sub-path, whilst the other communications sub-path 54,56 is designated as a redundant communications sub-path that may take over the function of the main communications sub-path in the event that the main communications sub-path is unable to communicate a signal. This thereby improves the reliability of the second electrode line monitoring assembly 140.

It is envisaged that, in other embodiments, the number of end and intermediate electrode line monitoring units in the second electrode line monitoring assembly 140 may vary to define a communications path that is divided into a different number of communications sub-paths.

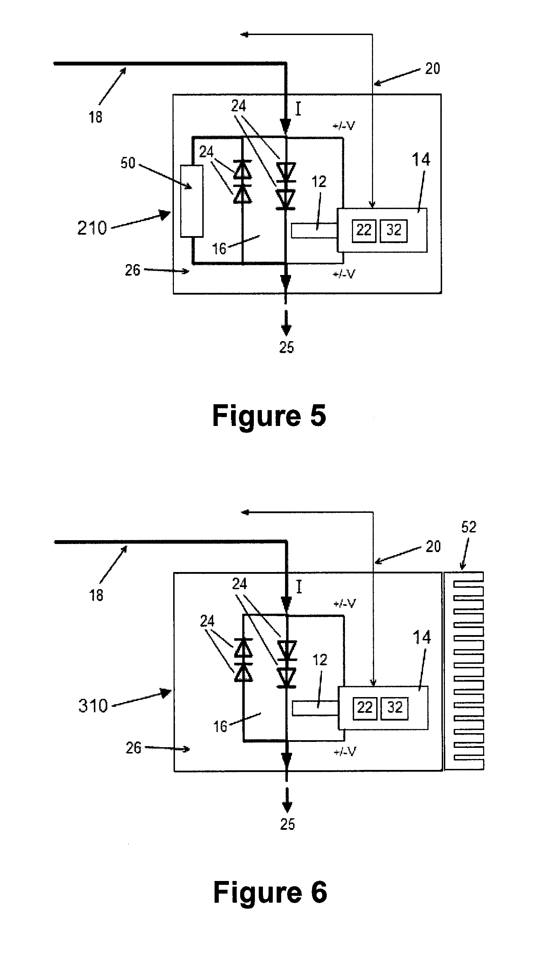

A third electrode line monitoring unit 210 according to a fifth embodiment of the invention is shown in Figure 5. The third electrode line monitoring unit 210 shown in Figure 5 is similar in terms of structure and operation to the first electrode line monitoring unit 10 shown in Figure 1, and like features share the same reference numerals.

The third electrode line monitoring unit 210 differs from the first electrode line monitoring unit 10 in that the third electrode line monitoring unit 210 further includes a battery 50 that is capable of storing and releasing its electrical energy to provide a voltage. The battery is electrically coupled to the power extraction circuit to selectively charge the battery 50.

Optionally the battery 50 may be independent of the power extraction circuit, i.e. not electrically coupled to the power extraction circuit to selectively charge the battery 50.

The inclusion of the battery 50 in the third electrode line monitoring unit 210 provides a secondary voltage source so as to power the sensor and communications devices 12,14 of the third electrode line monitoring unit 210. Thus, the battery is able to act as a back-up power supply to ensure reliable operation of the third electrode line monitoring unit 210, even when there is insufficient or zero current flow in the electrode line 18 to permit sufficient power to be harvested by the power extraction circuit.

The battery 50 may be replaced by another type of energy storage device is capable of storing and releasing its electrical energy to provide a voltage. Such an energy storage device may be, but is not limited to, a capacitor.

In other embodiments, it is envisaged that, in addition to or in place of the battery 50, the third electrode line monitoring unit 210 may include an energy conversion device that is capable of generating energy from the environment to provide a secondary voltage source so as to power the sensor and communications devices 12,14 of the third electrode line monitoring unit 210. Such an energy conversion device may be, but is not limited to, a solar cell.

It is further envisaged that the energy conversion device may instead be any type of energy conversion device that is capable of converting the type of energy stored by the energy storage device to and from electrical energy.

A fourth electrode line monitoring unit 310 according to a sixth embodiment of the invention is shown in Figure 6. The fourth electrode line monitoring unit 310 shown in Figure 6 is similar in terms of structure and operation to the first electrode line monitoring unit 10 shown in Figure 1, and like features share the same reference numerals.

The fourth electrode line monitoring unit 310 differs from the first electrode line monitoring unit 10 in that the fourth electrode line monitoring unit 310 further includes a heat sink 52. The heat sink 52 relies on convective heat transfer to dissipate heat generated during operation of the fourth electrode line monitoring unit 310. This thereby allows the temperature of the fourth electrode line monitoring unit 310 to be regulated within a designated temperature range to improve the safety and reliability of the fourth electrode line monitoring unit 310.

The heat sink 52 may be replaced by another type of cooling system that is able to dissipate heat to regulate the temperature of the fourth electrode line monitoring unit 310. Such a cooling system may be or may include, but is not limited to a heat pipe, a fan and/or a convection chimney.

It is envisaged that, in other embodiments of the invention, each of the electrode line monitoring units 10,110,210,310 and each of the electrode line monitoring assemblies 40,140 may include a combination of any of the features described with reference to the above embodiments.

## Claims

1. An electrode line monitoring unit for monitoring an electrode line comprising:
a communications device including a transmitter to transmit, in use, a signal; and
a power supply including a power extraction circuit for connection, in use, into the electrode line such that a voltage drop is generated across the power extraction circuit so as to provide a primary voltage source to power one or more other components of the electrode line monitoring unit, wherein the power extraction circuit includes at least one power electronic device with a non-linear voltage-current characteristic.

2. An electrode line monitoring unit according to any preceding claim wherein the signal includes one or more of:
information about one or more characteristics of the electrode line;
control instructions to control, in use, one or more electrode line monitoring units;
configuration data to configure, in use, one or more electrode line monitoring units;
information about a status of one or more end users and/or one or more electrode line monitoring units.

3. An electrode line monitoring unit according to any preceding claim further including a sensor device to measure, in use, one or more characteristics of the electrode line.

4. An electrode line monitoring unit according to Claim 2 or Claim 3 wherein the or each characteristic of the electrode line is selected from a group that includes line connectivity, current level and temperature.

5. An electrode line monitoring unit according to any preceding claim wherein the power extraction circuit includes a plurality of power electronic devices connected in an anti-parallel arrangement.

6. An electrode line monitoring unit according to any preceding claim wherein, upon failure of one or more power electronic devices, the or each failed power electronic device forms a short circuit that permits, in use, electrode line current to pass through the power extraction circuit.

7. An electrode line monitoring unit according to any preceding claim wherein the communications device is or includes an optical communications device, an electrical communications device and/or a radio communications device.

8. An electrode line monitoring unit according to any preceding claim wherein the communications device further includes a receiver to receive, in use, a signal.

9. An electrode line monitoring unit according to Claim 8 wherein the communications device includes a communications repeater device to retransmit, in use, a received signal, wherein the communications repeater device includes the transmitter and the receiver.

10. An electrode line monitoring unit according to Claim 9 wherein the communications device is a bidirectional communications device that includes a pair of transmitters and a pair of receivers, and includes two communications repeater devices to retransmit, in use, a received signal, wherein each communications repeater device includes a transmitter and a receiver.

11. An electrode line monitoring unit according to any preceding claim further including an energy storage device and/or an energy conversion device to provide a secondary voltage source so as to power one or more other components of the electrode line monitoring unit.

12. An electrode line monitoring unit according to Claim 11 wherein the energy storage device is electrically coupled to the power extraction circuit to selectively charge the energy storage device.

13. An electrode line monitoring unit according to any preceding claim wherein the electrode line monitoring unit further includes a cooling system to regulate a temperature of the electrode line monitoring unit.

14. An electrode line monitoring unit according to Claim 13 wherein the cooling system is or includes a heat sink, a heat pipe, a fan and/or a convection chimney.

15. An electrode line monitoring unit according to any preceding claim further including a support to hold components of the electrode line monitoring unit, the support being mountable or fastenable, in use, to the electrode line and/or a support structure of the electrode line.

16. An electrode line monitoring assembly for monitoring an electrode line comprising a communications path, wherein the communications path includes a plurality of electrode line monitoring units to communicate at least one signal along the communications path, and each of the plurality of electrode line monitoring units is an electrode line monitoring unit according to any preceding claim.

17. An electrode line monitoring assembly according to Claim 16 wherein the plurality of electrode line monitoring units includes:
at least one electrode line monitoring unit according to any of Claims 1 to 15, and
at least one other electrode line monitoring unit according to any of Claims 8 to 10,
wherein at least one of the plurality of electrode line monitoring units is in communication with at least one other of the plurality of electrode line monitoring units so as to communicate at least one signal along the communications path.

18. An electrode line monitoring assembly according to Claim 16 or Claim 17 wherein the communications path is divided into a plurality of communications sub-paths, wherein each communications sub-path includes at least one of the plurality of electrode line monitoring units to communicate a signal along that communications sub-path.
